# EUROPEAN PATENT SPECIFICATION

(11) **EP 2 183 610 B1**
(45) Date of publication and mention of the grant of the patent: **23.03.2016**
(21) Application number: 08803264.4
(22) Date of filing: 27.08.2008
(51) Int. Cl.: G01R 33/30, G01N 1/38, B01F 1/00, G01R 33/28, B01L 3/02, G01N 1/10, G01R 33/62

(54) **NOZZLE FOR A POLARIZER FOR DYNAMIC NUCLEAR SPIN POLARISATION (DNP)**
DÜSE FÜR EINEN POLARISATOR ZUR DYNAMISCHEN KERNSPINPOLARISATION
BUSE POUR POLARISEUR À POLARISATION NUCLÉAIRE DYNAMIQUE

(30) Priority: 28.08.2007 US 968320 P
(43) Date of publication of application: 12.05.2010
(73) Proprietor: GE Healthcare Limited, Little Chalfont, Buckinghamshire HP7 9NA (GB)
(72) Inventor: ARDENKJÆR-LARSEN, Jan, Henrik, Amersham, Buckinghamshire HP7 9LL (GB); DIETRICH, David, Key, Niskayuna, New York 12309 (US); GRAM, Karl, Andreas, N-0401 Oslo (NO); LEACH, Andrew, M., Clifton Park, New York 12065 (US); MILLER, Peter, New London, Connecticut 06320 (US); TELFEYAN, Eric, J., Guilderland, New York 12084 (US); THANING, Mikkel, N-0401 Oslo (NO); WHITT, David, B., Torrance 90504 CA (US)
(74) Representative: Livgard, Kim Are Birkeli
(86) International application number: PCT/EP2008/061197
(87) International publication number: WO 2009/027422

(56) References cited:
- EP-A- 0 078 109
- EP-A- 0 409 650
- WO-A-2004/109121
- GB-A- 1 445 061
- GB-A- 2 448 054
- WOLBER J ET AL: "Generating highly polarized nuclear spins in solution using dynamic nuclear polarization" NUCLEAR INSTRUMENTS & METHODS IN PHYSICS RESEARCH, SECTION - A:ACCELERATORS, SPECTROMETERS, DETECTORS AND ASSOCIATED EQUIPMENT, ELSEVIER, AMSTERDAM, NL, vol. 526, no. 1-2, 21 June 2004 (2004-06-21), pages 173-181, XP004830097 ISSN: 0168-9002

## Description

### Field of the Invention

The present invention is directed to the field of dynamic nuclear polarization (DNP). More specifically, the present invention is directed to a component for dynamic nuclear polarization equipment. Even more specifically, the present invention is directed to a feature of the dissolution equipment for a DNP polarizer, namely a nozzle as part of the dissolution device. This nozzle provides for more efficient dissolution of the solid polarized sample, thereby enabling a rapid and complete dissolution.

### Background of the Invention

Polarization by DNP in the solid state, i.e. at very low temperatures and a moderate to high magnetic field, followed by dissolution with a dissolution medium has been demonstrated to yield highly enhanced nuclear polarizations, which in turn enable a range of novel MR applications. Pyruvate for instance is a compound that plays a role in the citric acid cycle and DNP-polarized (hyperpolarized) pyruvate can be used as an MR agent *for in vivo* MR studying of metabolic processes in the human body. Hyperpolarized pyruvate may for instance be used as an MR imaging agent for *in vivo* tumour imaging as described in detail in WO-A-2006/011810 and for assessing the viability of myocardial tissue by MR imaging as described in detail in WO-A-2006/054903. To produce hyperpolarized pyruvate, pyruvic acid is DNP polarized and the solid frozen polarized pyruvic acid is dissolved and neutralized in a hot dissolution medium containing an aqueous buffer solution and a base. WO-A-2006/011809, which discloses the DNP polarization and dissolution of pyruvic acid.

The dissolution process itself has to be extremely rapid and complete. This generally requires a hot dissolution medium to be injected into a vial containing the frozen solid sample with the expectation that the thermal energy and flow of the dissolution medium will be sufficient to completely dissolve the sample and carry it to another container, see for instance WO-A-02/37132.

In the following the terms "solid frozen sample, solid sample and frozen sample" are used interchangeably. However, in actually reducing this process to practice a number of unexpected problems were observed. One possible failure mode was that the system freezes before the solid sample is dissolved, resulting in an ice plug either partially or completely blocking flow into and out of the system. A second failure mode was that the thermal energy transferred to the solid sample was not sufficient to dissolve all of it, resulting in some amount of solid sample being left in the vial. In addition to operating pressure and temperature it was determined that the inlet tube design and placement may play an important role in obtaining satisfactory dissolutions.

One prior approach to address this problem involves heating the dissolution media to a very high temperature and operating at very high pressures. By using this approach it is possible to rapidly dissolve a cryogenically frozen sample. Unfortunately, the pressures and temperatures required by this approach may also require expensive components made of heat and pressure resistant material and/or lead to safety issues. Furthermore, very high temperatures easily may lead to steaming of the dissolution medium, depending on the pressure. Steam is however less efficient in transferring heat to the frozen solid sample and thus to dissolve it than the liquid dissolution medium. Means to prevent steaming of the hot dissolution medium is therefore critical.

Moreover, a lengthy dissolution will inadvertently affect the nuclear polarization since polarization in the dissolved sample decays over time and variations in timing will result in a non-robust dissolution process yielding variable polarization. Additionally, incomplete dissolution will impact on the process yield. Moreover, in case of polarizing a free acid such as pyruvic acid that has to be neutralized upon dissolution, incomplete dissolution is detrimental for controlling the pH of the resulting solution. It is therefore desirable to implement features that contribute to a robust and expedient dissolution process.

This object is achieved with the DNP polarizer according to claim 1. The claim has been delimited against the article J. Wolber et al., "Generating highly polarized nuclear spins in solution using dynamic nuclear polarization", Nuclear Instruments and Methods in Physics Research A 526, 2004, 173-181.

### Brief Description of the Drawings

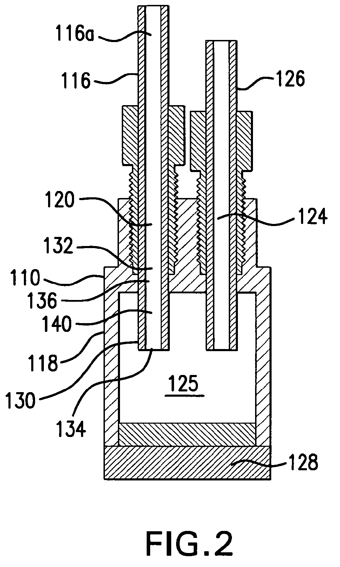

In the following, only Figure 2 illustrates an embodiment used in the present invention.
Figure 1 depicts a dissolution stick and sample container of the prior art.
Figure 2 depicts a docking house incorporating a nozzle according to the present invention.
Figure 3 depicts a dissolution stick.
Figure 4 depicts a container for holding a frozen polarized material.
Figure 5 depicts a container for holding a frozen polarized material.
Figure 6 depicts a dissolution stick for dissolving a frozen polarized material.
Figures 7A-C depict modifications of the nozzle of Figure 6
Figures 8A-B depict another dissolution stick.
Figure 9 depicts a nozzle at its location within the fluid flow path of a polarizer.
Figure 10 depicts a product sample vial, with its vial cap in place, positioned about a nozzle.
Figure 11 depicts a dissolution device.
Figure 12 depicts a method of making a nozzle.
Figure 13 shows a comparison between a dissolution wherein a nozzle is present (Figure 13B) and absent (Figure 13A).

### Detailed Description

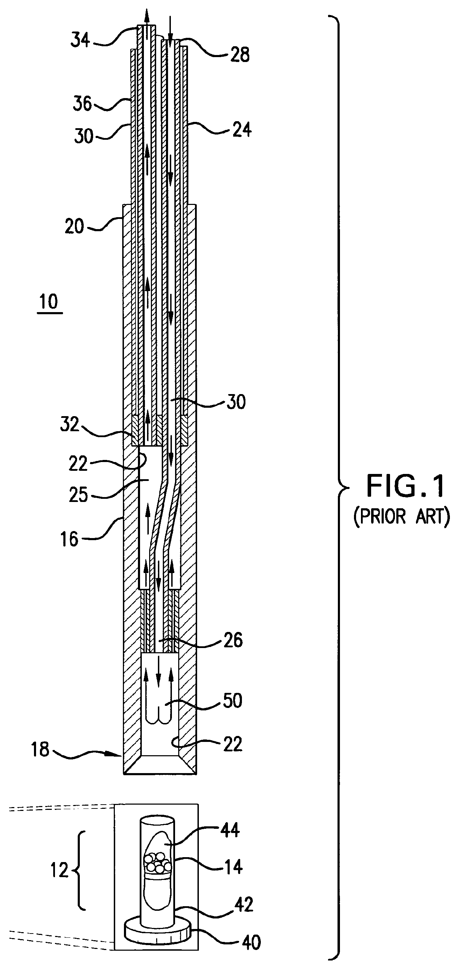

Figure 1 depicts a dissolution stick 10 and sample container 12 of the prior art. Dissolution stick 10 provides for dissolving a polarized sample material 14 held within sample container 12.

As used herein, the term "sample" refers to a polarized material, which is typically provided in a sample container, at a low temperature in a frozen solid state. The term "dissolution medium" refers to a liquid provided to melt and dissolve the sample material, thereby forming a "solution" of the melted and dissolved sample material and possibly also at least some of the dissolution medium. The temperature of the dissolution medium is generally higher than the temperature of the sample. The temperature of the sample is about 1 to 5 K while the temperature of the dissolution medium is at least room temperature, i.e. about 295 K but preferably a heated, i.e. hot dissolution medium is used. If an aqueous dissolution medium is used, e.g. an aqueous buffer solution, such an aqueous buffer solution may be heated to a temperature of about 355 K or more. Thus when the dissolution medium gets into contact with the sample, the sample is melted and dissolved. The terms "sample container" and "sample vial" is contemplated as holding the sample in both its frozen solid form and in its solution form.

Dissolution stick 10 includes an elongate tubular outer housing 16 having open opposed first open end 18 and second open end 20. Housing 16 provides an interior surface 22 defining an elongate cavity 25 extending in fluid communication between open first end 18 and open second end 20. Dissolution stick 10 supports a first elongate conduit 24 having opposed first open end 26 and second open end 28 and an elongate flowpath 30 extending in fluid communication between open ends 26 and 28. Second open end 28 is provided connected to a source of a liquid dissolution medium (not shown). Dissolution stick 10 further includes a second elongate conduit 30 having opposed first open end 32 and second open end 34 and an elongate withdrawal path 36 extending in fluid communication between open ends 32 and 34. Withdrawal path 36 provides a route for conducting the dissolution medium and the dissolved sample material originally provided by container 12.

Sample container 12 typically includes a planar base 40 supporting an upstanding open cylindrical wall 42 defining a sample receptacle 44 in which the sample material is provided. When container 12 is inserted into open end 18 of dissolution stick 10, wall 42 sealingly engages interior surface 22 of housing 16 so as to prevent fluid leakage therebetween. Dissolution stick 10 and container 12 define a sample cavity 50 into which the sample material is held as dissolution medium is provided from first open end 26 of first conduit 24. The mixture of the dissolution medium and the dissolved sample material is withdrawn from cavity 50 through withdrawal path 36 of second conduit 30 to a receiver location where it can be further processed for providing a hyperpolarized material suitable for *in vitro* NMR analysis or for in *vivo use.*

The present invention provides for the incorporation of a nozzle adjacent to the sample cavity so as to increase the flow velocity of the dissolution medium onto the sample material. Desirably, the nozzle of the present invention also directs the flow of the dissolution medium so as to provide efficient dissolution of the sample material in the sample cavity. As will be more fully described hereinbelow, the design and placement of the nozzle may be optimized to obtain complete and rapid dissolution of the sample material. Desirably, the nozzle provides fluid flow through the sample cavity that promotes the conduct of the dissolved sample material through the withdrawal conduit and does not form eddies or vortices where dissolved sample material becomes entrapped in the cavity.

Thus, the present invention provides the ability to fully dissolve a cryogenically frozen sample in a closed fluid path. The present invention also provides the ability to transfer the dissolved product from a vial to a receiver. Additionally, the present invention provides the ability to modify the placement of a nozzle/inner tube such that complete dissolution may be obtained regardless of the amount of material in the vial. The present invention further provides the ability to modify the size and shape of a nozzle to improve dissolution at varying operating temperatures and pressures. Additionally, the present invention provides the ability to use a larger diameter inner tube to maintain high mass flow rates while still achieving high fluid velocity at the exit.

Figure 2 depicts an embodiment of the present invention, a docking house 110 incorporating a nozzle. Docking house 110 may be incorporated into a dissolution stick or separately incorporated into a polarizer at the end of the polarization process. Docking house 110 fits snugly over a sample container 12 containing a frozen polarized sample 14. Once sample container 12 is attached to docking house 110 a volume of dissolution medium is sent through a conduit 116 leading into docking house 110. Docking house 110 has a housing body 118 defining three openings; a dissolution medium port 120 for accommodating conduit 116 through which the dissolution medium is provided, a solution port 124 for accommodating a solution conduit 126 through which the solution of sample and dissolution medium is driven out, and a sample port 128 for receiving sample container 12 in a fluid-tight connection. Docking house 110 defines a sample cavity 125 into which a frozen polarized sample is provided. Typically, sample cavity 125 is completely defined between body 118 and a sample container (not shown), which holds the frozen sample to be dissolved.

As seen in Figure 2, Docking house 110 includes a nozzle 130 provided within dissolution medium port 120. Nozzle 130 includes an input port 132, a dispense port 134, and a nozzle flowpath 136 extending in fluid communication therebetween. Nozzle 130 desirably includes a conically-tapering inner wall 140 which further defines flowpath 136. As will be appreciated for each embodiment of the present invention, dispense port 134 is characterized by a cross-sectional area which is smaller than the cross-sectional area of the flow passageway 116a of conduit 116. The present invention is thus able to accelerate the flow rate of the dissolution medium, through dispense port 134 as compared to the flow rate through conduit 116 upstream of dispense port 134. Moreover, the nozzles of the present invention are desirably oriented in a manner, which directs dissolution medium flow onto the frozen sample.

One of skill in the art will appreciate that the design of the nozzle affects the efficiency of the dissolution. Here, a conically tapering inner surface of the nozzle will greatly improve the performance of the dissolution, both in terms of clearing the entire solid sample content of the sample container, and in terms of providing an expedient dissolution process that preserves the nuclear polarization during the transition. As will be seen, however the present invention contemplates additional designs for the nozzle of the present invention. Additionally, the present invention contemplates that the nozzle will be formed from a material, which does not react with the materials with which it will come into contact and which will not adversely affect the polarization levels of the sample material.

While Figure 2 presents nozzle 130 as part of docking house 110, the present invention further contemplates that nozzle 130 may be incorporated directly onto the free end of conduit 116. Therefore, another implementation is a nozzle, which is part of a closed fluid path ending in a sample vial that contains the solid sample. In fact, the nozzle is a favorable feature of any arrangement in the context of a polarizer from which samples are retrieved by dissolution. It is thus further contemplated that docking house 10 may be a fixture within the polarizer. The sample container would then be serially inserted into and withdrawn from docking house 10 so as to enable dissolution of successive samples in accordance with the present invention.

It has been demonstrated that the end orifice diameter of the nozzle is critical to the dissolution efficiency. The optimal diameter will of course depend on a number of parameters such as the depth and shape of the sample container, amount of sample and the chosen pressure for the dissolution medium.

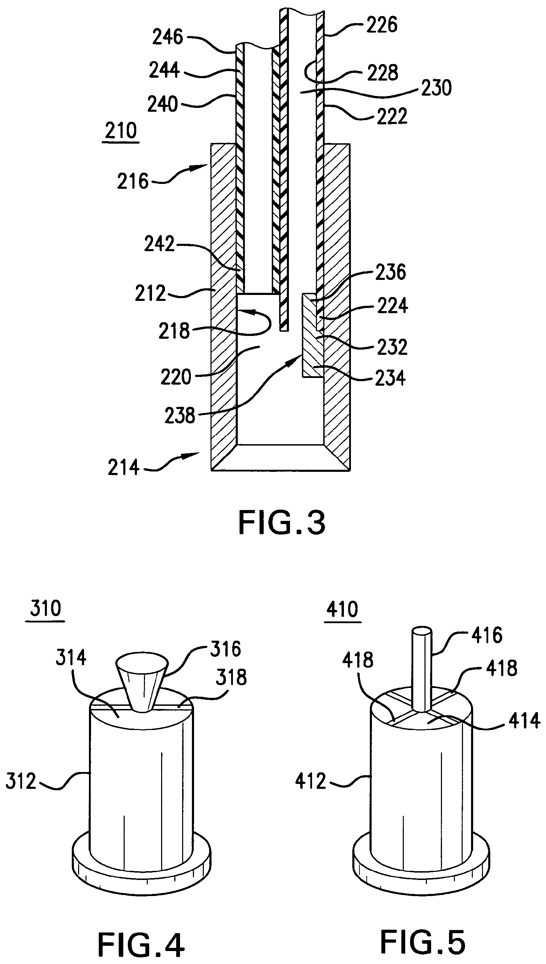

Figure 3 depicts a dissolution stick 210 for dissolving a frozen polarized sample material held within sample container 12. Dissolution stick 210 includes an elongate tubular outer housing 212 having opposed first open end 214 and second open end 216 and an interior surface 218 defining an elongate cavity 220 extending in fluid communication between open ends 214 and 216. Dissolution stick 210 supports a first elongate conduit 222 having opposed first open end 224 and second open end 226. Second open end 226 of conduit 222 is connectable to source of dissolution medium. Conduit 222 includes an inner surface 228 defining an elongate dissolution medium flowpath 230 extending in fluid communication between open ends 224 and 226.

Dissolution stick 210 provides a constriction member 232 having opposed first and second ends, 234 and 236, respectively. Constriction member 232 is supported on interior surface 218 of housing 212. First end 234 of constriction member 232 extends into first open end 224 of conduit 222 so as to reduce the available cross-sectional area of flowpath 230 at first open end 224. Constriction member 232 will thus cause an acceleration of the dissolution medium through open end 224 as compared to its flow rate in conduit 222 upstream thereof. Constriction member 232 further includes an exterior surface 238 which may be shaped, or angled, relative to flowpath 230 so as to direct fluid flowing out of first open end 224 of conduit 222 towards a location of choice within cavity 220. The particular direction for dissolution medium flow from conduit 222 will be influenced by the dimensions and geometry of cavity 220 as well as the desired flow rate of the dissolution medium entering cavity 220.

Dissolution stick 210 also supports a second elongate conduit 240 having opposed first and second open ends 242 and 244, respectively. Conduit 240 defines an elongate withdrawal path 246 extending in fluid communication between open ends 242 and 244. Second open end 244 of conduit 240 is connectable to a collector or receiver for the solution withdrawn from cavity 220.

Figure 4 depicts a sample container 310 for holding a frozen polarized material within a dissolution stick or docking house. Sample container 310 includes a container body 312 defining a sample receptacle 314 for receiving the frozen polarized sample material. Container body 312 is adapted to engage a device for dissolving and withdrawing the dissolved polarized material, such as a dissolution stick or docking house. The particular device will include a first conduit for providing a dissolution medium at a first fluid velocity and a second conduit for withdrawing the polarized material after dissolution thereof. Container body 312 supports a nozzle 316 in overlying registry with sample receptacle 314 so as to accelerate the dissolution medium to a second fluid velocity greater than the first fluid velocity. A nozzle brace 318 ensures the proper positioning of nozzle 316 with respect to the dissolution medium conduit. That is, nozzle 316 is placed over the open end of a dissolution medium conduit so that all of the dissolution medium flowing through the dissolution medium conduit exits through the nozzle dispense port 318. Dispense port 318 is characterized by a smaller cross-sectional area than the dissolution medium conduit over which it is placed.

Figure 5 depicts a sample container 410 for holding a frozen polarized sample material within a dissolution stick or docking house. Sample container 410 includes a container body 412 defining a sample receptacle 414 for receiving the polarized material. Container body 412 is adapted to engage a device for dissolving and withdrawing the dissolved polarized material, such as a dissolution stick or docking house. The particular device will include a first conduit for providing a dissolution medium at a first fluid velocity and a second conduit for withdrawing the polarized material after dissolution thereof. Container body 412 supports a constrictor 416 in overlying registry with sample receptacle 414 so as to accelerate the dissolution medium to a second fluid velocity greater than the first fluid velocity. A constrictor brace 418 ensures the proper positioning of constrictor 416 with respect to the dissolution medium conduit. That is, constrictor 416 is placed partly into the open end of a dissolution medium conduit so that all of the dissolution medium flowing through the dissolution medium conduit must exit the conduit through a dispense port thus formed. The dispense port is characterized by a smaller cross-sectional area, spanning between constrictor 41 and the inner wall of the conduit, than the dissolution medium conduit upstream from constrictor 416.

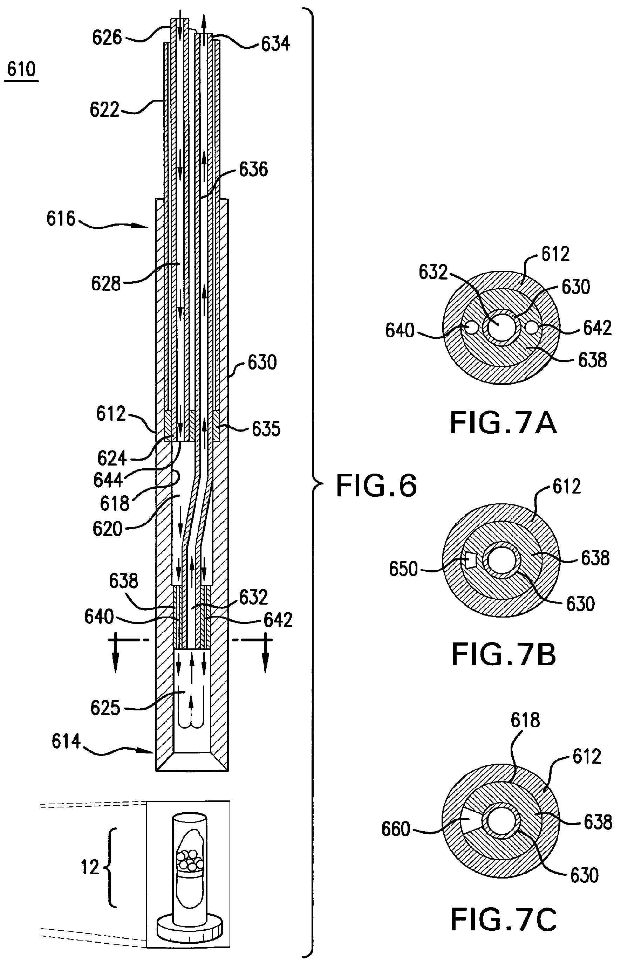

Figure 6 depicts a dissolution stick 610 for dissolving a frozen polarized sample material. Dissolution stick 10 provides for dissolving a polarized sample material held within sample container 12, which has been inserted thereinto. Dissolution stick 610 is essentially a modification of dissolution stick 10 so as to incorporate a nozzle while the fluid flow direction is reversed. Dissolution stick 610 includes an elongate tubular outer housing 612 having opposed first open end 614 and second open end 616. Housing 612 includes an interior surface 618 defining an elongate cavity 620 extending in fluid communication between open ends 614 and 616. The portion of cavity 620 adjacent open end 614 provides sample cavity 625 into which sample container 12 is inserted. Dissolution stick 610 supports an elongate dissolution medium conduit 622 having opposed first and second open ends 624 and 626, respectively, and an elongate dissolution medium flowpath 628 extending in fluid communication therebetween. Dissolution stick 610 further includes an elongate solution conduit 630 having opposed first and second open ends 632 and 634, respectively, and an elongate withdrawal path 636 extending in fluid communication therebetween. Gasket member 635 is provided to seal outer housing 612 such that fluid flow remains confined to conduits 622 and 630 and to sample cavity 625.

First open end 624 of first conduit 622 is positioned within cavity 618 of outer housing 612 upstream from first open end 632 of second conduit 630. First open end 632 of second conduit 630 is centrally-supported within cavity 620 of outer housing 612 by annular support 638. As seen in Figure 7A, annular support 638 defines flow ports 640 and 642 at a location between second conduit 630 and interior surface 618 of outer housing 612. In accordance with the present invention, the total cross-sectional area provided by flow ports 640 and 642 is less than the total cross-sectional area of the dispense port 644 defined by first open end 624 of first conduit 622.

Figures 7B-C depict alternate examples of nozzles incorporated into the dissolution stick of Figure 6. In Figure 7B, annular support 638 defines a single flow port 650 located midway between solution conduit 630 and outer housing 612. In Figure 7C, annular support 638 defines a single flow port 660 extending from second conduit 630 to interior surface 618 of housing 612. In each instance, the total cross-sectional area of the flow ports provided by annular support 638 is less than the cross-sectional area of dispense port 644, resulting in an accelerated flow rate into sample cavity 620.

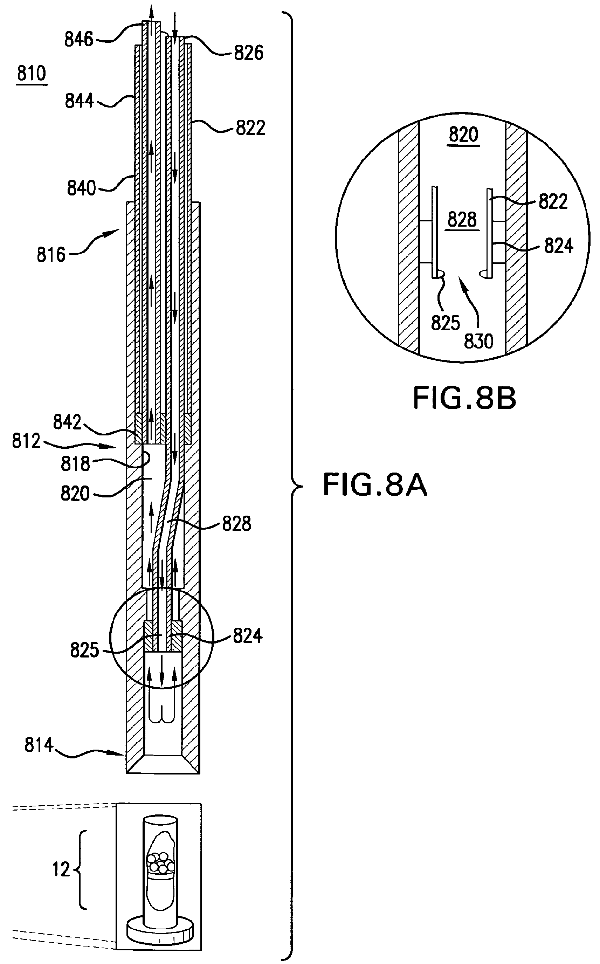

Figures 8A-B depict a dissolution stick 810, which provides for dissolving a polarized sample material held within sample container 12. Dissolution stick 810 is substantially identical in construction to dissolution stick 10, but with the provision of a nozzle for accelerating fluid flow. Dissolution stick 810 includes an elongate tubular outer housing 812 having opposed first open end 814 and second open end 816. Housing 812 includes an interior surface 818 defining an elongate cavity 820 extending in fluid communication between open first and second ends 814 and 816. Dissolution stick 810 also includes a first elongate conduit 822 having opposed first and second open ends 824 and 826, respectively, and an elongate flowpath 828 extending in fluid communication therebetween. Second open end 826 is positionable in fluid communication with a source of dissolution medium. First open end 824 of first conduit 822 includes a nozzle 825 defining a flow port 830 having a cross-sectional dimension smaller than a cross-sectional dimension of flowpath 828 upstream of nozzle 825. It is contemplated by the present invention that nozzle 825 may be formed by the method described hereinbelow, however, any nozzle which serves to accelerate fluid flow therethrough is contemplated.

Dissolution stick 810 further supports a second elongate conduit 840 having opposed first and second open ends 842 and 844, respectively, and an elongate withdrawal path 846 extending in fluid communication therebetween. Second open end 844 of second conduit 840 is positionable in fluid communication with a withdrawal destination for the dissolution medium.

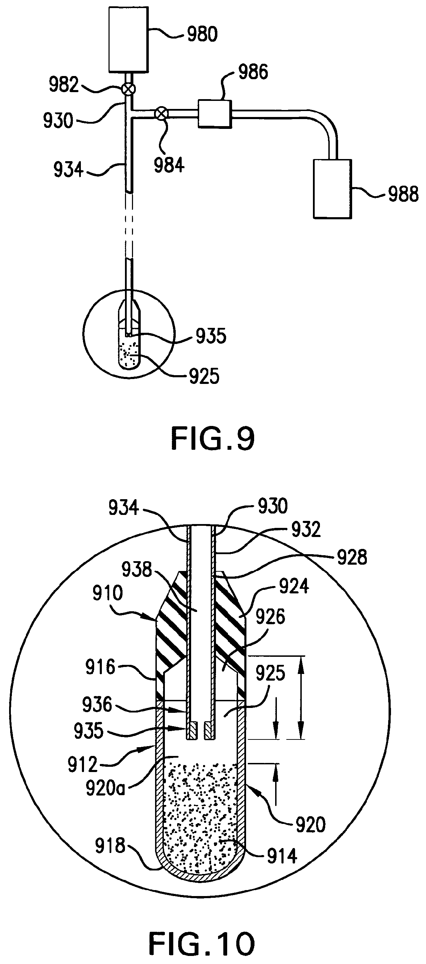

Figure 9 shows a nozzle 935 at its location within the fluid flow path of a polarizer. Figure 10 depicts a vial cap 910 which is connectable to a sample container 912 providing a frozen polarized sample material 914. Sample container 912 includes an open first end 916, a closed second end 918, and an elongate cylindrical wall 920 extending therebetween. Wall 920 includes an interior surface 920a defining a sample cavity 925. Vial cap 910 includes a cap body 924, which defines a sample port 926 for fluid-tight reception of open end 916 of sample container. Sample cavity 925 is thus fully defined when sample container 912 is mated to vial cap 910.

Vial cap 910 further defines a single flow port 928 therethrough, which accommodates both a dissolution medium conduit 930 and a solution conduit 932. Dissolution medium conduit 930 is concentrically supported within solution conduit 932 so that dissolution medium provided through dissolution medium conduit 930 into sample cavity 925 causes the frozen sample material to dissolve and flow out the annular withdrawal path 934 about dissolution medium conduit 930.

Dissolution medium conduit 930 further includes a first open end 936 having a nozzle 935. Nozzle 935 is a constriction in the dissolution medium flowpath 938 defined by dissolution medium conduit 930, which causes an acceleration in fluid flow therethrough as compared to the fluid flowrate in conduit 930 upstream of nozzle 935.

The central location of nozzle 935 over sample cavity 925 provides the fluid flow characteristics which rapidly and completely dissolve a cryogenically frozen product in cavity 925, as well as which fully displace the product solution through withdrawal path 934 to a final location where it is collected into receiver vessel 988, as shown in Figure 9.

Referring again to Figure 9, a syringe 980 containing the dissolution medium is connected to dissolution medium conduit 930. Upon the opening of valve 982 syringe 980 may dispense the dissolution medium into dissolution medium conduit 930 and through nozzle 935 into sample cavity 925. A solution of the dissolution medium and the dissolved hyperpolarized sample material, due to the continued provision of dissolution medium from syringe 980, is directed through withdrawal path 934. The solution is directed through a valve 984, in the open state, through filter 986 and into receiver 988 where the solution is collected. The present invention contemplates that at the conclusion of a run virtually all of the originally frozen sample material will arrive in receiver 988.

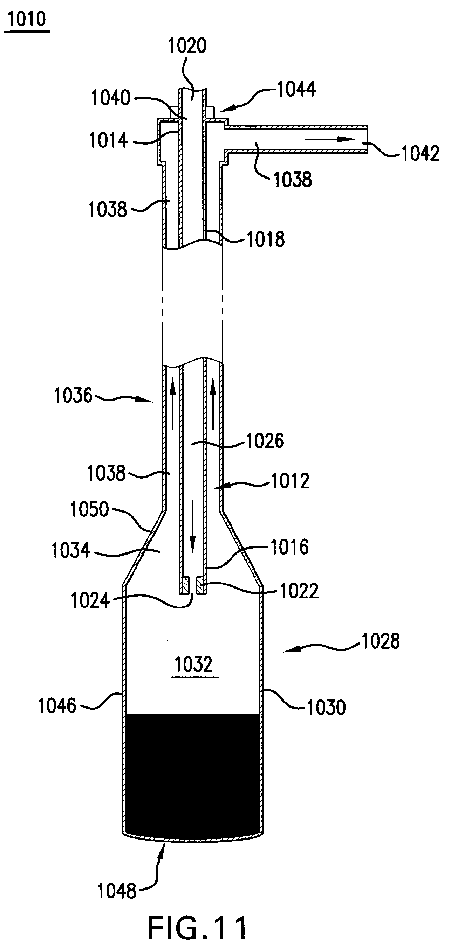

Figure 11 shows a dissolution device 1010 which may be incorporated within a polarizer. Dissolution device 1010 includes a first elongate tube 1012 having opposes first end and second ends, 1014 and 1016, respectively, and an elongate tubular wall 1018 extending therebetween. First end 1014 defines a first port 1020 to be positioned in fluid communication with a source of a dissolution fluid (not shown, but similar as described for Figure 9) and second end 1016 includes an exit nozzle 1022. Exit nozzle 1022 defines a nozzle port 1024. Tubular wall 1018 defines an elongate delivery passageway 1026 extending between ports 1020 and 1024. Nozzle port 1024 is shaped to accelerate fluid flow from passageway 1026 therethrough as described for other examples above.

Dissolution device 1010 includes an outer housing 1028 having an outer housing wall 1030 which defines a sample cavity 1032 for holding a frozen polarized sample. Sample cavity 1032 is in fluid communication with nozzle port 1024. Outer housing wall 1030 defines a fluid withdrawal port 1034 in fluid communication with sample cavity 1032. Outer housing 1028 further includes an elongate outer tubular wall 1036 extending from outer housing wall 1030. Outer tubular wall 1036 defines an elongate withdrawal passageway 1038 extending in fluid communication with fluid withdrawal port 1034.

First elongate tube 1012 extends within withdrawal passageway 1038 of outer tubular wall 1036. Outer housing wall 1030 further defines an access port 1040 for accommodating first elongate tube 1012 therethrough. Outer tubular wall 1036 further defines an outlet port 1042 in fluid communication with withdrawal passageway 1038. The present invention further contemplates that first elongate tube 1012 may be slideably mounted by a mounting sleeve 1044 which maintains the fluid integrity of withdrawal passageway 1038 while also allowing first elongate tube 1012 to be extended and retracted within withdrawal passageway 1038 so as to selectively position nozzle 1022 with respect to sample cavity 1032.

Outer housing wall 1030 further includes an elongate cylindrical sample retaining wall 1046 extending from a transversely-oriented endwall 1048. A tapering frustroconical wall 1050 extends between elongate cylindrical sample retaining wall 1046 and elongate outer tubular wall 1036. While walls 1036, 1046, and 1050 are shown in Figure 11 to form a continuous unitary tubular wall, the present invention further contemplates that frustroconical wall 1050 may be provided by vial cap 910, as described in Figure 10, so that sample retaining wall 1046 is removably connectable to frustroconical wall 1050 to allow user access to sample cavity 1032.

Similar to the depiction of Figure 9, dissolution device 1010 may be connected to a syringe, or other dispensing source, containing the dissolution medium at the first end of first elongate tube. The dissolution medium is thus provided into first elongate tube 1012 and through nozzle 1022 into sample cavity 1032. A solution of the dissolution medium and the dissolved hyperpolarized sample material, due to the continued provision of dissolution medium, is directed through withdrawal passageway 1038. The solution is directed through outlet port 1034 towards a waiting receiver. The present invention contemplates that at the conclusion of a run virtually all of the originally frozen sample material will arrive in receiver.

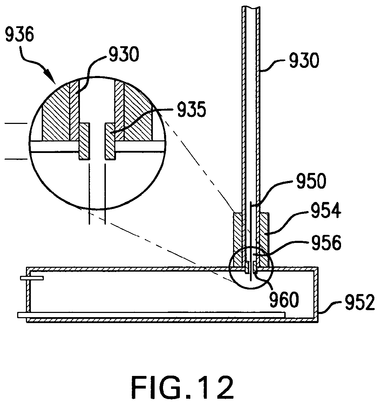

Through experimentation and modeling it was discovered that in order to accomplish this reliably it was advantageous to place a nozzle at the end of the inner tube and to locate that nozzle within a certain distance of the frozen sample, Figure 12. This parameter, called standoff, is defined as the distance between the surface of the frozen sample and the nozzle. Experimentally it has been determined that the closer the nozzle is placed to the surface the better the dissolution that results. Unfortunately, it has also been observed that placing the nozzle too close to the surface can lead to a blockage if the sample melts and refreezes at any time prior to the injection of the dissolution medium.

In the preferred example the nozzle diameter is 0.9mm and the standoff is set to be 5mm. This is with an outer tube inner diameter of 2.69mm and an inner tube outer diameter of 1.83mm, resulting in a ratio of flow areas of approximately 1.6 in favor of exiting the system.

Figure 12 depicts one method of making nozzle 935. Nozzle 935 is prepared by positioning first end 936 of dissolution medium conduit 930 over an elongate vertically-extending pin 950 supported by a heating block 952. Heating block 952 is desirably an electro-thermal device, which heats upon the supply of electrical power. An elongate cylindrical brass guide 954 defining an elongate conduit passageway 956 therethrough is concentrically supported about pin 950. As heating block 952 heats towards a melting temperature of the conduit material, the conduit material will begin to flow towards pin 950. Conduit 930 may be further brought towards heating block 952 as the conduit material flows. Open end 936 of conduit 930 thus reforms about pin 950. When the now-deformed conduit has sufficiently cooled, conduit 930 may be withdrawn from brass guide 954 and off of pin 950.

To further assist the formation of nozzle 935, heating block 952 may define a conduit-receiving depression 960 into which open end 936 is first inserted. Pin 950 would be centrally supported in depression 960. It is further contemplated that the heating of block 952 may occur simultaneously to the step of deforming conduit 930. Alternatively, conduit 930 may be provided to an already heated block 952 to cause the deformation. By this method, a nozzle with a certain length and diameter has been formed in conduit 930. This technique has been utilized to form orifices with a range of diameters and depths.

While the particular embodiment of the present invention has been shown and described, it will be obvious to those skilled in the art that changes and modifications may be made without departing from the teachings of the invention. The matter set forth in the foregoing description and accompanying drawings is offered by way of illustration only and not as a limitation. The actual scope of the invention is intended to be defined in the following claims when viewed in their proper perspective based on the prior art.

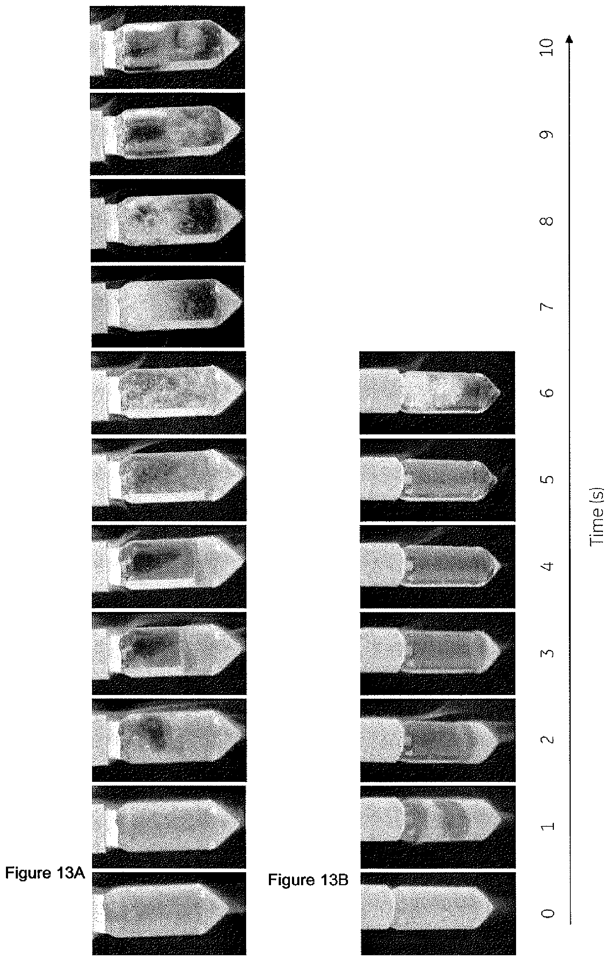

A demonstration of the impact of a nozzle on the dissolution process in shown in Figure 13.

2.2 grams of pyruvic acid was dissolved with 50 mL of water (dissolution medium) that is heated to 130 °C and pressurized to 250 PSI. Red food coloring was added to the pyruvic acid to aid in the visualization of this dissolution process.

Figure 13A displays the dissolution process in the absence of a nozzle. In this example the open aperture of the first conduit was 1.6 mm in diameter and resulted in a linear fluid velocity of approximately 4 m/s. The 50 mL of dissolution medium was consumed approximately 6 s after the dissolution had commenced, at which time the remaining unmelted acid was not recoverable from the system.

Figure 13B displays the dissolution process in the presence of a muzzle, i.e. nozzle. In this example the open aperture of the first conduit was reduced to 0.9 mm using the previously described method of nozzle fabrication. With this flow restriction a linear fluid velocity of greater than 12 m/s was achieved. The impact of higher velocity liquid jet was the rapid melting of the center of the acid sample (time = 1 s) followed by the more gradual melting of the remaining acid in a radial direction. With the nozzle in place the acid was completely melted in approximately 4 s, well before the dissolution medium was completely consumed.

By completing the melting process before the dissolution medium is consumed, the acid recovery efficiency of this system was enhanced relative to a system without a nozzle.

## Claims

1. DNP polarizer comprising a device for dissolving a frozen polarized sample, the device comprising a sample container (12) and a housing body (118); the sample container (12) being removably connectable to the housing body (118); and
the housing body (118) having three openings:
- a dissolution medium port (120) accommodating a conduit (116) for introducing a dissolution medium;
- a solution port (124) for accommodating a solution conduit (126) for removal of dissolved sample; and
- a sample port (128) for receiving the sample container (12) into a sample cavity (125) provided in said housing body (118);
**characterized in that**
- **the device further** comprises a nozzle (130) adjacent to the sample cavity (125);
- wherein the nozzle is provided within the dissolution medium port (120); and
- wherein the nozzle (130) includes an input port (132), a dispense port (134) and a nozzle flow path (136) extending in fluid communication there between; wherein the dispense port (134) has a cross-sectional area which is smaller than the cross-sectional area of a flow passage way (116a) of said conduit (116) for introducing a dissolution medium, so as to increase the flow velocity of the dissolution medium onto the frozen polarized sample.

2. Device according to claim 1, wherein the nozzle (130) is oriented in a manner which directs dissolution medium flow onto the frozen polarized sample.

3. Device according to claim 1, wherein the sample port (128) is positioned opposed to the dissolution medium port (120).

4. Use of a DNP polarizer according to any one of the preceding claims to dissolve a frozen, polarized sample.

## Patentansprüche

1. DNP-Polarisator umfassend eine Vorrichtung zum Auflösen einer gefrorenen polarisierten Probe, wobei die Vorrichtung einen Probebehälter (12) und einen Gehäusekörper (118) umfasst; wobei der Probebehälter (12) mit dem Gehäusekörper (118) lösbar verbindbar ist; und
der Gehäusekörper (118) drei Öffnungen aufweist:
- eine Öffnung für Auflösungsmedium (120), welche einen Kanal (116) für das Einführen eines Auflösungsmediums aufnimmt;
- eine Lösungsöffnung (124) für die Aufnahme eines Lösungskanals (126) für das Entfernen von aufgelöster Probe; und
- eine Probenöffnung (128) für die Aufnahme des Probebehälters (12) in einen Probenhohlraum (125), welcher in dem Gehäusekörper (118) vorgesehen ist;
**dadurch gekennzeichnet, dass**
- die Vorrichtung ferner eine Düse (130) umfasst, die an den Probenhohlraum (125) angrenzend angeordnet ist;
- wobei die Düse innerhalb der Öffnung für Auflösungsmedium (120) vorgesehen ist; und
- wobei die Düse (130) eine Eingangsöffnung (132), eine Abgabeöffnung (134) und einen Düsenströmungsweg (136) umfasst, welcher sich in der dazwischen vorliegenden Fluidverbindung erstreckt; wobei die Abgabeöffnung (134) einen Querschnittsbereich aufweist, welcher kleiner ist als der Querschnittsbereich eines Strömungsdurchlasses (116a) des Kanals (116) für das Einführen eines Auflösungsmediums, um die Strömungsgeschwindigkeit des Auflösungsmediums auf die gefrorene polarisierte Probe zu erhöhen.

2. Vorrichtung nach Anspruch 1, wobei die Düse (130) derart ausgerichtet ist, dass die Strömung des Auflösungsmediums auf die gefrorene polarisierte Probe hinauf gerichtet wird.

3. Vorrichtung nach Anspruch 1, wobei die Probenöffnung (128) zur Öffnung für Auflösungsmedium (120) entgegengesetzt angeordnet ist.

4. Verwendung eines DNP-Polarisators nach einem der vorgehenden Ansprüche zur Auflösung einer gefrorenen, polarisierten Probe.

## Revendications

1. Polariseur DNP comprenant un dispositif pour dissoudre un échantillon polarisé congelé, ledit dispositif comprenant un récipient d'échantillon (12) et un corps de boîtier (118); ledit récipient d'échantillon (12) étant connectable de manière amovible au corps de boîtier (118); et
ledit corps de boîtier (118) ayant trois ouvertures:
- un port de milieu de dissolution (120) logeant un conduit (116) pour introduire un milieu de dissolution;
- un port de solution (124) pour loger un conduit de solution (126) pour l'élimination d'un échantillon dissous; et
- un port d'échantillon (128) pour recevoir le récipient d'échantillon (12) dans une cavité d'échantillon (125) pourvue dans le corps de boîtier (118);
**caractérisé en ce que**
- le dispositif comprend en outre une buse (130) adjacent à la cavité d'échantillon (125);
- dans lequel la buse est pourvue dans le port de milieu de dissolution (120); et
- dans lequel la buse (130) comprend en outre un port d'entrée (132), un port de distribution (134) et un chemin d'écoulement de buse (136) s'étendant dans une communication de fluide entre ceux-ci; dans lequel le port de distribution (134) présente une surface de section transversale qui est inférieure à la surface de section transversale d'un trajet de passage d'écoulement (116a) dudit conduit (116) pour introduire un milieu de dissolution, pour augmenter la vitesse d'écoulement du milieu de dissolution à l'échantillon polarisé congelé.

2. Dispositif selon la revendication 1, dans lequel la buse (130) est orientée d'une telle manière que l'écoulement de milieu de dissolution est dirigé à l'échantillon polarisé congelé.

3. Dispositif selon la revendication 1, dans lequel le port d'échantillon (128) est positionné à l'opposé du port de milieu de dissolution (120).

4. Utilisation d'un polariseur DNP selon l'une quelconque des revendications précédentes pour dissoudre un échantillon polarisé congelé.
